# EUROPEAN PATENT SPECIFICATION

(11) **EP 2 946 275 B1**
(45) Date of publication and mention of the grant of the patent: **30.10.2019**
(21) Application number: 13871751.7
(22) Date of filing: 15.01.2013
(51) Int. Cl.: G06F 3/048, G06F 3/044, G06F 3/046, G06F 3/02, G06F 3/0354, H03K 17/96

(54) **INPUT DEVICE**
EINGABEVORRICHTUNG
DISPOSITIF DE SAISIE

(43) Date of publication of application: 25.11.2015
(73) Proprietor: Nokia Technologies Oy, 02610 Espoo (FI)
(72) Inventor: CHEN, Zhigang, Beijing 102206 (CN); LI, Yong, Beijing 100102 (CN); XIA, Zheng, Beijing 101300 (CN); SHANG, Ligang, Beijing 100018 (CN)
(74) Representative: Espatent Oy
(86) International application number: PCT/CN2013/070482
(87) International publication number: WO 2014/110715

(56) References cited:
- CN-A- 101 751 191
- CN-A- 102 841 705
- CN-Y- 201 118 545
- US-A1- 2005 030 048
- US-A1- 2008 094 373
- US-A1- 2009 079 695
- US-A1- 2009 219 257

## Description

### TECHNICAL FIELD

The present application generally relates to an input device.

### BACKGROUND

Touchscreens have become very common as they enable very simple and intuitive pointing operations, for example. However, touchscreens have some disadvantages such as that for touching a given part of the touchscreen, the user has to partly obscure the touchscreen with her finger. The touching also tends to smear the surface of the touchscreen so that increased brightness may be needed with the associated cost at battery life. Moreover, actual keys are generally more convenient for typing as they usually provide a clear tactile response with a key depressed issuing a sudden decrease in the key force, click action, coinciding with reading of a key press.

Sometimes, touchscreens and keypads are combined by arranging a keypad near a touchscreen. Thus, best of both worlds can be combined, although the issues with touchscreens still remain.

US 2005/030048 A1 discloses a capacitive sensing device for use in a keypad assembly of an electronic device. The capacitive sensing device has a transparent single sheet capacitive sensor that is disposed within the keypad assembly without formation of key post holes through the sheet. The transparent sheet is made flexible to enable desired tactile response during use of keys so that underlying switch sensors can be depressed through the flexing transparent sheet. The transparent sheet is made using a single layer of transparent conductive material such as indium tin oxide (ITO) and an extra layer of substantially opaque conductive material to protect the transparent conductive material against cracking during manufacture and/or repetitive use. US-2009/079695 A1 discloses touch pad with a capacitive sensor touch pad and plurality of operation keys operating key.

### SUMMARY

The invention is defined by the independent claims. Further aspects of the invention are outlined in the dependent claims. When the term embodiment is used for describing unclaimed combinations of features, the term has to be understood as referring to examples useful for understanding the present invention.

### BRIEF DESCRIPTION OF THE DRAWINGS

For a more complete understanding of example embodiments of the present invention, reference is now made to the following descriptions taken in connection with the accompanying drawings in which:
Fig. 1 shows an apparatus according to an example embodiment of the invention;
Fig. 2 shows a perspective drawing of an example of some components with which a combined touch detection and key detection can be provided;
Fig. 3 shows the components of Fig. 2 when assembled;
Fig. 4 illustrates a section view of some parts of an apparatus that comprises a combined touch detection and key press detection;
Fig. 5 shows a process for forming electromagnetic detectors for the apparatus of Fig. 1 according to one example embodiment;
Fig. 6 shows a section of some components of an apparatus according to an example embodiment; and
Fig. 7 shows a key detection circuitry according to an example embodiment.

### DETAILED DESCRIPTON OF THE DRAWINGS

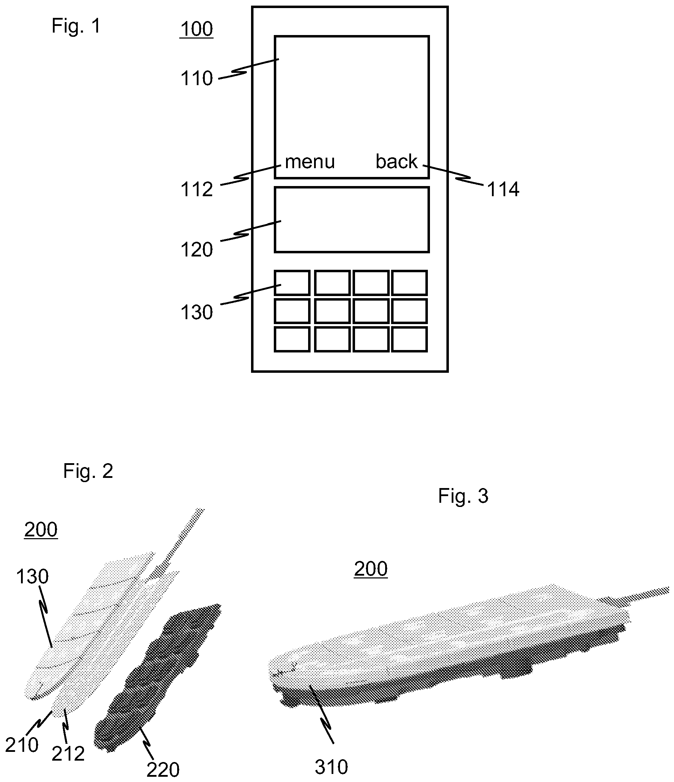

An example embodiment of the present invention and its potential advantages are understood by referring to Figs. 1 through 7 of the drawings.

Fig. 1 shows an apparatus 100 according to an example embodiment of the invention. The apparatus 100 of this example is a portable device such as a mobile telephone; navigation device; game console; electronic book; a laptop computer; and / or personal digital assistant. The apparatus 100 comprises a display 110 such as a liquid crystal display; an organic light emitting diode display; or an electric ink display. The display can be configured to display any graphics and text, with two soft key legends 112 and 114 shown near one edge of the display 110 for an example. Next to the display or adjacent to the display 110 a touch control surface 120 is provided for use e.g. as known from touch pads. Additionally, the touch control surface 120 can be used to implement one or more soft keys so that on touching a region of the touch control surface 120 next to a soft key legend 112, 114, a corresponding action is taken. The apparatus 100 further comprises one or more keys 130 e.g. in the form of a keypad or keyboard.

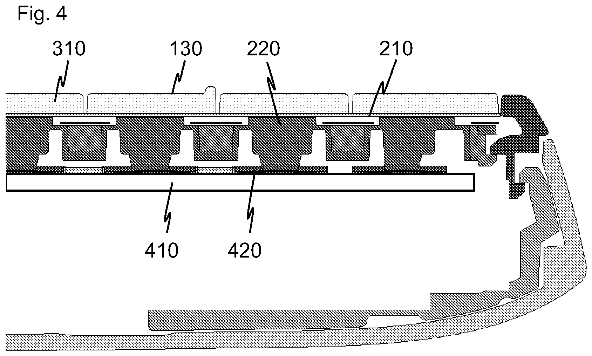

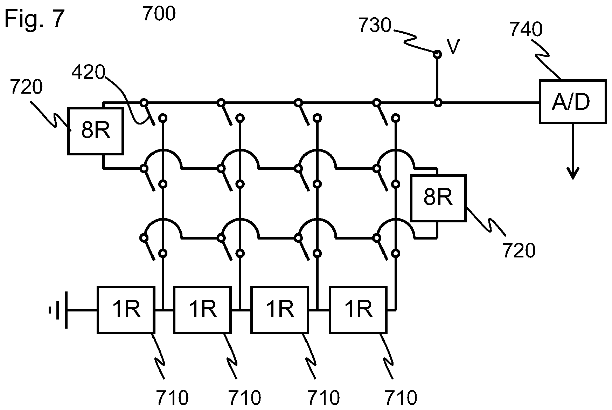

The keys 130 together form a touch surface on which a user can hover or slide her finger e.g. for controlling the apparatus 100. In embodiments with the touch control surface 120, the touch control surface 120 and the touch surface of the keys 130 can be used together as one large touch area through which user input may be read by touch detection while the keys 130 can still be used as normal keys. Fig. 2 illustrates an example of some components with which a combined touch detection and key detection can be provided. Fig. 3 shows the components of Fig. 2 when assembled. The keys 130 together form an exterior layer 310 behind which there is a sensing layer 210 carrying key sensing layer that has a network of electromagnetic detectors 212 e.g. as printed antennas. The exterior layer 310 is in an example embodiment 0.5 mm to 1.5 mm or more thick. The sensing layer 210 is e.g. 0.1 to 1 mm thick. In one example embodiment, the sensing layer 210 is 0.15 mm to 0.3mm thick. Further behind the sensing layer 210 there is shown a rubber layer (e.g. of natural or synthetic rubber or thermoplastic polyurethane) 220 that is configured to act as an elastic layer that relies on key presses to underlying key sensing circuitry (see Fig. 4 for domes 420 and Fig. 7 for an example of a key sensing circuitry).

Fig. 4 illustrates a section view of some parts of an apparatus that comprises a combined touch detection and key press detection. The sensing layer 210 is located immediately behind the keys 130 (or touch surface or touch layer) so that a finger tip or stylus touching the touch surface or top of the keys 130 can be detected e.g. with capacitive sensing. On the other hand, if a key 130 is pressed, the key press is relayed through the sensing layer 210 and the rubber layer 220 to the key sensing circuitry (e.g. key dome 420). With the rubber layer 220 in between, the tactile response can be made more convenient and clicking sound be somewhat reduced. Moreover, the rubber layer 220 provides a degree of softness and voids at borders between keys so that the touch sensing layer 210 can flex with larger radius than if being placed directly between the keys 130 and the key domes 420. Moreover, the rubber layer 220 can be configured to reduce mechanical shocks and thus extend lifetime of the key sensing circuitry.

The key tops 130 on the touch surface are configured in one example embodiment to identify one or more keys to a user. The key tops can be formed of a single sheet of plastic for example or discrete parts. If formed of a single sheet, then the different keys can be identified by a suitable pattern, for example. With discrete parts, the boundaries or borders of the key tops form the identification.

The key sensing circuitry is in one example embodiment a matrix of signal lines that cross at each dome and the key press is determined by detecting which signal lines become connected together on pressing a key. In another example embodiment, each key has an independent connection that enables simultaneous detection of pressing of two or more keys. An example of a key detection circuitry will be described in the following with reference to Fig. 7. In an alternative embodiment the key sensing circuitry can comprise two or more conductive tracks that may be shorted together to indicate the presence of a physical touch. In yet another example embodiment, the key sensing circuitry comprises a surface acoustic wave sensor. Various known techniques can be used for the key sensing and thus this part is not explained any further.

The operation of touch sensors as such is known and thus needs no detailed description. However, Fig. 2 illustrates the electromagnetic detectors 212 around each key. This arrangement is provided to illustrate one example embodiment in which connectors are deliberately formed between contacting portions of the key tops and the electromagnetic detectors 212. With the rubber layer 220 having protrusions aligned with the keys, there are gaps between the protrusions where the electromagnetic detectors 212 are not likely to be abraded when the keys are being pressed. The electromagnetic detectors 212 are yet so aligned and monitored that a touch at any key or region between any keys is detected by an assigned touch detector (not shown). In one example embodiment, the electromagnetic detectors 212 are arranged in a grid that is not necessarily aligned with the key tops.

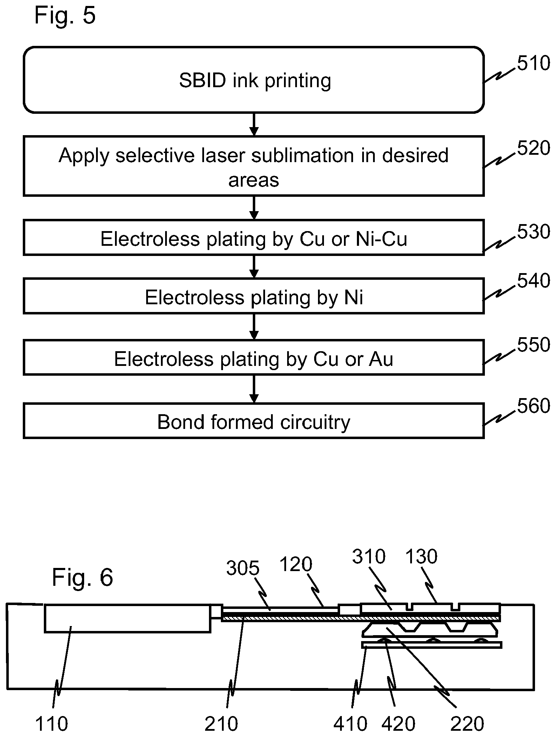

In one example embodiment, selective activation plating is used for forming the electromagnetic detectors 212. In broad terms, energy beams can be used to sublimate selectively plastics areas so as to expose particular nano-size particles encapsulated in a polymer matrix of the plastics. This can efficiently promote electroless plating so that only the selected area can be plated. For instance, super energy beam induced deposition (SBID) is used in forming the electromagnetic detectors 212 to the touch sensing layer 210 as shown in Fig. 5. In step 510, sheet material (e.g. a plastic film) is first printed with a suitable SBID ink. Following the printing, laser sublimation 520 is selectively applied in desired areas. Then, electroless plating 530 by Cu,Ni-Cu is performed, an electroless plating 540 by Ni is performed and an electroless plating 550 by Cu or Au is performed. The formed circuitry is then bonded 560 to the touch sensing layer 210. The bonding is made in one example embodiment with a bond flexible printed circuit (FPC) for connecting to a printed wire board (PWB) e.g. using thermo-sensitive adhesive In the SBID, a pattern can be formed on substrate that comprises e.g. polycarbonate (PC) and / or polycarbonate - acrylonitrile butadiene styrene (PC-ABS) with active particles. Sublimation part of the SBID can be made by laser etching.

Fig. 6 shows a section of some components of an apparatus according to an example embodiment, such as the apparatus 100 of Fig. 1. Fig. 6 also exemplifies an embodiment in which the touch sensing layer 210 extends beyond the touch surface formed by the keys 130 to sense touching at the touch control surface 120. In other words, the touch surface has a first region and a second region non-overlapping the first region; and the key tops are solely comprised by the first region.

Fig. 6 also shows another layer such as a plastic film 305 covering the touch sensing layer 210 at the touch control surface 120. In another example embodiment (not shown), there is no separate layer covering the touch sensing layer 210 at the touch control surface. Instead, the touch sensing layer 210 can be uncovered at this region. For protection against scratching, a lacquer treatment or painting is applied at this region in one example embodiment.

Fig. 6 also shows a sectional view of an exterior layer 310 comprising a first side configured to form the touch surface. The exterior layer 310 is e.g. formed of a single layer e.g. of plastic material. The plastic material can be flexible such as polyethylene (high density), polypropylene, polyurethane, synthetic rubber, nylon, ethylene vinyl acetate, polyvinyl chloride, and/or thermoplastic elastomer. Alternatively, the exterior layer 310 can be formed of rigid material such as non-flexible plastic material or metal with flexible connections allowing a degree of deforming in the exterior layer. In an example embodiment, the touch sensing layer 210 is resiliently biased with the elastic layer against the exterior layer 310 such that on pressing one of the one or more key tops, the movement of the touch sensing layer 210 is greater with respect to the pressed key top. When the touch sensing layer 210 can move over a greater area than the key top above, the touch sensing layer 210 can be made of less flexible materials and / or tensions incurred in the touch sensing layer 210 be reduced.

While Fig. 6 shows separate layers for the key press detection, touch detection and for the key tops as well as the rubber layer 220, some example embodiments combine layers together. For instance, in one example embodiment, the electromagnetic detectors are formed on rear side of the exterior layer 310 that forms the key tops. In another example embodiment, the electromagnetic detectors are instead formed onto the rubber layer 220, on a side that is nearer to the exterior layer 310.

Fig. 7 shows a key detection circuitry 700 according to an example embodiment. The key detection circuitry is configured to form varying resistance between a voltage supply node 720 and ground using suitably connected and dimensioned resistors 710, 720. When a key is pressed, a corresponding dome 420 connects lines crossing at the dome thus forming paths of individual resistance to the ground so that the voltage at the voltage supply indicates the key that is being pressed. With suitable connection, two or more simultaneously pressed keys can also be detected. As a detector, the key detection circuitry 700 comprises an analogue to digital converter 740.

Without in any way limiting the scope, interpretation, or application of the claims appearing below, a technical effect of one or more of the example embodiments disclosed herein is that touch detection can be combined with key press detection with simple and reliable equipment. Another technical effect of one or more of the example embodiments disclosed herein is that the equipment for combined touch and key press detection can be made very thin. Another technical effect of one or more of the example embodiments disclosed herein is that electromagnetic touch detectors can be located immediately behind the key tops. This can further enhance reliability of the touch detection. Yet another technical effect of one or more of the example embodiments disclosed herein is that the locating of the electromagnetic touch detectors immediately behind the key tops can enable lowering power of the electromagnetic touch detectors and thus reduce internal interference on other components and power consumption. The reducing internal interference can further reduce need for internal shielding. In battery operated devices, reduction of power consumption can enable extending battery life or reducing battery size.

If desired, the different functions discussed herein may be performed in a different order and/or concurrently with each other. Furthermore, if desired, one or more of the before-described functions may be optional or may be combined.

## Claims

1. An apparatus (200), comprising:
a touch layer comprising a touch surface that comprises one or more key tops (130) configured to identify one or more keys to a user;
a key sensing circuitry (420) configured to detect a key press of any one or more of the key tops (130);
a sensing layer that has a network (210) of capacitive touch detectors configured to continually detect touching of the touch surface; and
an elastic layer (220) between the key sensing circuitry (420) and the key tops (130) configured to relay pressing forces from the key tops (130) to the key sensing circuitry (420); wherein:
the network (210) of touch detectors is formed onto the elastic layer (220) or onto a rear surface of an exterior layer (310) that forms the key tops (130); and
the sensing layer is located immediately behind the touch layer.

2. The apparatus (200) of claim 1, wherein:
the elastic layer (220) comprises rubber or thermoplastic polyurethane.

3. The apparatus (200) of claim 1 or 2, wherein:
the network of touch detectors is formed by super energy beam induced deposition.

4. The apparatus (200) of any preceding claim, wherein:
the touch surface has a first region and a second region non-overlapping the first region; and
the key tops are solely comprised by the first region.

5. A device comprising:
a display (110); and
the apparatus (200) of any of the preceding claims.

6. The device of claim 5, wherein:
the device is a mobile telephone.

7. The device of claim 6, wherein:
the device is a laptop computer and the apparatus is configured to form a touch pad.

8. A method comprising:
forming a touch layer comprising a touch surface comprising one or more key tops (130) configured to identify one or more keys to a user;
forming a key sensing circuitry (420) configured to detect a key press of any one or more of the key tops (130);
forming a sensing layer that has a network (210) of capacitive touch detectors configured to continually detect touching of the touch surface;
forming an elastic layer (220) between the key sensing circuitry (420) and the key tops (130) configured to relay pressing forces from the key tops (130) to the key sensing circuitry (420);and
forming the network (210) of touch detectors onto the elastic layer (310) or onto a rear surface of an exterior layer (310) that forms the key tops (130);
wherein the sensing layer is located immediately behind the touch layer.

9. The method of claim 12, wherein the network (210) of touch detectors is formed super energy beam induced deposition.

## Patentansprüche

1. Vorrichtung (200), umfassend:
eine Berührungsschicht umfassend eine Berührungsoberfläche, die eine oder mehrere Tastenoberseiten (130) umfasst, die zum Identifizieren einer oder mehrerer Tasten für einen Benutzer ausgelegt sind;
eine Tastenerkennungsschaltung (420), die zum Erkennen eines Tastendrucks eines oder mehrerer der Tastenoberseiten (130) ausgelegt ist;
eine Erfassungsschicht, die ein Netzwerk (210) von kapazitiven Berührungsdetektoren aufweist, die zum kontinuierlichen Erfassen der Berührung der Berührungsoberfläche ausgelegt sind; und
eine elastische Schicht (220) zwischen der Tastenerfassungsschaltung (420) und den Tastenoberseiten (130), die zum Weiterleiten von Druckkräften von den Tastenoberseiten (130) zu der Tastenerfassungsschaltung (420) ausgelegt ist; wobei:
das Netzwerk (210) von Berührungsdetektoren auf der elastischen Schicht (220) oder auf einer hinteren Oberfläche einer Außenschicht (310) ausgebildet ist, die die Tastenoberseiten (130) bildet; und
die Sensorschicht befindet sich unmittelbar hinter der Berührungsschicht.

2. Vorrichtung (200) nach Anspruch 1, wobei:
die elastische Schicht (220) Gummi oder thermoplastisches Polyurethan umfasst.

3. Vorrichtung (200) nach Anspruch 1 oder 2, wobei:
das Netzwerk der Berührungsdetektoren durch eine durch Superenergiestrahlen induzierte Abscheidung gebildet wird.

4. Vorrichtung (200) nach einem beliebigen der vorhergehenden Ansprüche, wobei:
die Berührungsoberfläche einen ersten Bereich und einen zweiten Bereich, der den ersten Bereich nicht überlappt, aufweist; und
die Tastenoberseiten ausschließlich von dem ersten Bereich umfasst werden.

5. Gerät, umfassend:
eine Anzeige (110); und
die Vorrichtung (200) nach einem beliebigen der vorhergehenden Ansprüche.

6. Gerät nach Anspruch 5, wobei:
das Gerät ein Mobiltelefon ist.

7. Gerät nach Anspruch 6, wobei:
das Gerät ein Laptop-Computer ist und die Vorrichtung zum Bilden eines Touchpads ausgelegt ist.

8. Verfahren, umfassend:
Bilden einer Berührungsschicht umfassend eine Berührungsoberfläche, die eine oder mehrere Tastenoberseiten (130) umfasst, die zum Identifizieren einer oder mehrerer Tasten für einen Benutzer ausgelegt sind;
Bilden eine Tastenerkennungsschaltung (420), die zum Erkennen eines Tastendrucks eines oder mehrerer der Tastenoberseiten (130) ausgelegt ist;
Bilden eine Erfassungsschicht, die ein Netzwerk (210) von kapazitiven Berührungsdetektoren aufweist, die zum kontinuierlichen Erfassen der Berührung der Berührungsoberfläche ausgelegt sind;
Bilden eine elastische Schicht (220) zwischen der Tastenerfassungsschaltung (420) und den Tastenoberseiten (130), die zum Weiterleiten von Druckkräften von den Tastenoberseiten (130) zu der Tastenerfassungsschaltung (420) ausgelegt ist; und
Bilden des Netzwerks (210) von Berührungsdetektoren auf der elastischen Schicht (310) oder auf einer hinteren Oberfläche einer Außenschicht (310), die die Tastenoberseiten (130) bildet;
wobei sich die Erfassungsschicht unmittelbar hinter der Berührungsschicht befindet.

9. Verfahren nach Anspruch 12, wobei das Netzwerk (210) von Berührungsdetektoren durch eine durch Superenergiestrahlen induzierte Abscheidung gebildet wird.

## Revendications

1. Appareil (200), comprenant :
une couche tactile comprenant une surface tactile qui comprend un ou plusieurs dessus de touche (130) configurés pour identifier une ou plusieurs touches pour un utilisateur ;
des circuits de détection de touche (420) configurés pour détecter une pression de touche d'un ou de plusieurs dessus de touche (130) ;
une couche de détection qui présente un réseau (210) de détecteurs de contact capacitifs configurés pour détecter en continu un contact de la surface tactile ; et
une couche élastique (220) entre les circuits de détection de touche (420) et les dessus de touche (130) configurés pour relayer des forces de pression des dessus de touche (130) aux circuits de détection de touche (420) ; dans lequel :
le réseau (210) de détecteurs de contact est formé sur la couche élastique (220) ou sur une surface arrière d'une couche extérieure (310) qui forme les dessus de touche (130) ; et
la couche de détection est située directement derrière la couche tactile.

2. Appareil (200) selon la revendication 1, dans lequel :
la couche élastique (220) comprend du caoutchouc ou du polyuréthane thermoplastique.

3. Appareil (200) selon la revendication 1 ou 2, dans lequel :
le réseau de détecteurs de contact est formé par dépôt induit par faisceau super-énergétique.

4. Appareil (200) selon l'une quelconque des revendications précédentes, dans lequel :
la surface tactile présente une première région et une deuxième région ne chevauchant pas la première région ; et
les dessus de touche sont compris uniquement dans la première région.

5. Dispositif, comprenant :
un affichage (110) ; et
l'appareil (200) selon l'une quelconque des revendications précédentes.

6. Dispositif selon la revendication 5, dans lequel :
le dispositif est un téléphone mobile.

7. Dispositif selon la revendication 6, dans lequel :
le dispositif est un ordinateur portable et l'appareil est configuré pour former un pavé tactile.

8. Procédé, comprenant les étapes consistant à :
former une couche tactile comprenant une surface tactile comprenant un ou plusieurs dessus de touche (130) configurés pour identifier une ou plusieurs touches pour un utilisateur ;
former des circuits de détection de touche (420) configurés pour détecter une pression de touche d'un ou de plusieurs dessus de touche (130) ;
former une couche de détection qui présente un réseau (210) de détecteurs de contact capacitifs configurés pour détecter en continu un contact de la surface tactile ;
former une couche élastique (220) entre les circuits de détection de touche (420) et les dessus de touche (130) configurés pour relayer des forces de pression des dessus de touche (130) aux circuits de détection de touche (420) ; et
former le réseau (210) de détecteurs de contact sur la couche élastique (220) ou sur une surface arrière d'une couche extérieure (310) qui forme les dessus de touche (130) ;
dans lequel la couche de détection est située directement derrière la couche tactile.

9. Procédé selon la revendication 12, dans lequel le réseau (210) de détecteurs de contact est formé par dépôt induit par faisceau super-énergétique.
